(19) Europäisches Patentamt
European Patent Office
Office européen des brevets

(11) **EP 2 383 892 B1**

(12) **FASCICULE DE BREVET EUROPEEN**

(45) Date de publication et mention
de la délivrance du brevet:
**06.03.2013 Bulletin 2013/10**

(51) Int Cl.:
***H03M 1/18*** *(2006.01)*

(21) Numéro de dépôt: **11163017.4**

(22) Date de dépôt: **19.04.2011**

(54) **Dispositif de quantification, récepteur de signaux radiofréquence comprenant un tel dispositif et procédé de quantification**

Quantifizierungsvorrichtung, Funksignalempfänger, der eine solche Vorrichtung umfasst, und Quantifizierungsverfahren

Quantification device, radiofrequency signal receiver including said device and quantification method.

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.04.2010 FR 1052988**

(43) Date de publication de la demande:
**02.11.2011 Bulletin 2011/44**

(73) Titulaire: **Commissariat à l'Énergie Atomique et aux Énergies Alternatives 75015 Paris (FR)**

(72) Inventeur: **Lachartre, David 38330 Montbonnot (FR)**

(74) Mandataire: **Bonnet, Michel Cabinet Bonnet 93, Rue Réaumur - Boîte 10 75002 Paris (FR)**

(56) Documents cités:
**US-B1- 7 324 037**

EP 2 383 892 B1

**Description**

La présente invention concerne un dispositif de quantification, un récepteur de signaux radiofréquence comprenant un tel dispositif et un procédé de quantification.

Les signaux radiofréquence sont aussi généralement appelés signaux radio et par extension les récepteurs de signaux radiofréquence sont qualifiés de récepteurs radio.

Dans la description et les revendications qui vont suivre, la terminologie suivante sera utilisée.

Un « signal analogique » est un signal qui peut varier de manière continue à la fois dans le temps et en amplitude.

Un « signal numérique » est un signal prenant des valeurs discrètes, à intervalles réguliers dans le temps.

Un « signal échantillonné » est un signal changeant de valeur à intervalles réguliers dans le temps.

Un signal « à temps continu » est un signal non échantillonné, c'est-à-dire pouvant changer de valeur n'importe quand.

Un « signal quantifié » est un signal pouvant prendre des valeurs discrètes dans le temps à tout instant.

Un « signal binaire » est un signal quantifié pouvant prendre deux valeurs au maximum. Un signal quantifié pouvant prendre plus de deux valeurs peut être transmis sous la forme de plusieurs signaux binaires, chacun représentant un bit du signal quantifié.

« Décimer » signifie supprimer une partie des échantillons d'un signal échantillonné afin de sous échantillonner ce dernier.

Un « cycle » d'un signal binaire est la portion du signal s'étendant depuis une transition prédéterminée du signal, par exemple la transition de sa valeur haute à sa valeur basse, jusqu'à la transition prédéterminée suivante. Dans le cas d'un signal périodique, un cycle correspond donc à une période du signal.

Un « dispositif de quantification », ou « quantificateur », est un dispositif qui transforme un signal en un signal quantifié, c'est-à-dire qui fournit un signal quantifié dont la valeur dépend de la valeur du signal analogique au cours du temps.

L' « enveloppe positive », appelée par la suite simplement « enveloppe », d'un signal est une courbe de fréquence faible par rapport à la fréquence principale du signal et cherchant à rejoindre les pics (maxima locaux) du signal entre eux. Dans le cas d'une porteuse modulée uniquement en amplitude, l'enveloppe est la modulation d'amplitude. Un signal prenant des valeurs positives et négatives présente également une enveloppe négative cherchant à rejoindre les pics vers le bas (minima locaux) du signal entre eux. Dans le cas d'un signal symétrique par rapport à zéro, l'enveloppe négative est sensiblement égale à l'opposée de l'enveloppe positive.

Un convertisseur analogique-numérique est souvent un élément essentiel des dispositifs électroniques, en particulier des récepteurs radio d'architecture numérique où le signal radio issu de l'antenne doit être numérisé.

Il existe plusieurs techniques qui présentent des compromis très différents.

L'article intitulé « 1V 5-bit 5GS/s CMOS ADC for UWB receivers », de I. Wang et S. Liu publié dans International Symposium on VLSI Design, Automation and Test, 2007, VLSI-DAT 2007, 25-27 Avril 2007, pages 1-4, propose un récepteur radio muni d'un convertisseur analogique-numérique rapide qui échantillonne le signal radio à au moins deux fois sa plus haute fréquence et sur un nombre de bits relativement important. Comme le signal radio à recevoir peut avoir une dynamique supérieure à 50dB, une quantification sur au moins 8 bits peut être nécessaire. Par ailleurs, plus la fréquence radio est élevée plus la fréquence d'échantillonnage doit être grande. Par exemple un signal émis à 2,4 GHz doit être échantillonné à au moins 4,8 GS/s (i.e. taux d'échantillonnage). Un inconvénient de ce convertisseur est qu'il est très gourmant en énergie, sa puissance pouvant atteindre plusieurs watts.

Par ailleurs, l'article intitulé « A Subsampling Radio Architecture for Ultrawideband Communications », de S-W Chen et E. W. Brodersen, publié dans IEEE Transactions on Signal Processing, Volume 55, Issue 10, Oct. 2007, pages 5018-5031, propose un récepteur radio comportant un convertisseur analogique-numérique conçu pour échantillonner le signal radio à moins de deux fois sa fréquence. C'est ce qui est appelé du « sous-échantillonnage ». La contrainte de vitesse du convertisseur est relâchée d'autant plus que le signal est sous-échantillonné mais au détriment de la qualité du signal converti. En particulier le sous-échantillonnage a pour effet de replier le spectre autour de la fondamentale et des harmoniques de la fréquence d'échantillonnage. Ce repliement fait apparaître dans la bande du signal radio des signaux parasites issus des bandes de fréquence repliées. Cette technique de conversion analogique-numérique du signal radio nécessite en général un filtrage initial pour supprimer tous les signaux parasites susceptibles de se replier. Plus le signal sera sous-échantillonné, plus le filtrage devra être resserré autour de sa bande. De plus, la fréquence d'échantillonnage ne pourra tout de même pas descendre en dessous de la largeur de la bande du signal radio au risque de la replier elle-même. Même lorsque le signal est sous-échantillonné, le problème de la quantification nécessitant un grand nombre de bits de dynamique subsiste. En outre, la fréquence d'échantillonnage ne peut pas descendre aussi bas qu'on pourrait le souhaiter.

Le nombre de bits de quantification que l'on rencontre habituellement pour convertir les signaux radio a de l'importance vis-à-vis de la complexité et donc de la consommation du traitement numérique à réaliser pour obtenir un récepteur radio complet. Ainsi, même si le convertisseur analogique-numérique n'est pas la charge de consommation électrique principale, un grand nombre de bits de quantification va pénaliser la consommation de l'ensemble. Il est important de minimiser ce nombre quelle que soit la fréquence d'échantillonnage choisie.

Pour éviter les difficultés de l'échantillonnage, certains convertisseurs analogique-numérique comportent tout d'abord un quantificateur en temps continu, le signal n'étant échantillonné que plus tard dans la chaîne de réception.

Ainsi, la demande de brevet français publiée sous le numéro FR 2 922 388 décrit un dispositif de quantification d'un signal analogique comportant un circuit électronique conçu pour fournir un signal binaire, appelé signal de signe, prenant une première valeur lorsque le signal d'entrée est positif et prenant une seconde valeur lorsque le signal d'entrée est négatif, et un circuit électronique conçu pour fournir un signal quantifié sur plusieurs bits représentant l'amplitude du signal analogique.

Ce quantificateur présente toujours l'inconvénient de nécessiter un grand nombre de bits de quantification.

Le brevet publié sous le numéro US 7,324,037 décrit un dispositif de quantification en temps continu d'un signal analogique d'entrée, pour la fourniture d'un signal de sortie à temps continu quantifié sur deux bits (SIGN et MAGN), comportant un circuit électronique d'analyse de signe, conçu pour fournir un premier bit de signe (SIGN) du signal de sortie, prenant à tout instant une première valeur lorsque le signal d'entrée est positif et une seconde valeur lorsque le signal d'entrée est négatif. Il comporte en outre un circuit d'analyse d'amplitude, conçu pour fournir un second bit d'amplitude (MAGN) du signal de sortie, prenant à tout instant une première valeur, lorsque l'amplitude est supérieure à une valeur positive « upper threshold » ou inférieure à une valeur négative « lower threshold », et une seconde valeur sinon.

Il peut ainsi être souhaité de prévoir un quantificateur qui permette de s'affranchir d'au moins une partie des problèmes et contraintes précités, en particulier un quantificateur transformant le signal analogique en un signal quantifié sur peu de bits.

L'invention a donc pour objet un dispositif de quantification en temps continu d'un signal analogique, appelé signal d'entrée, pour la fourniture d'un signal de sortie quantifié sur deux bits, comportant un circuit électronique, appelé circuit d'analyse de signe, conçu pour fournir un premier bit du signal de sortie, appelé bit de signe, prenant à tout instant une première valeur lorsque le signal d'entrée est positif et une seconde valeur lorsque le signal d'entrée est négatif, et un circuit électronique, appelé circuit d'analyse d'enveloppe, conçu pour fournir un second bit du signal de sortie, appelé bit de variation d'enveloppe, prenant à tout instant une première valeur, appelée valeur haute, lorsqu'un signal d'enveloppe du signal d'entrée croît, et une seconde valeur, appelée valeur basse, lorsque le signal d'enveloppe décroît.

Ainsi, grâce à l'invention, il est possible d'obtenir un signal quantifié sur seulement deux bits (bit de signe et bit de variation d'enveloppe), qui représente relativement fidèlement le signal d'entrée. Par ce biais, le quantificateur de l'invention fournit donc une décomposition du signal d'entrée en la variation de son enveloppe et son signe.

Il est à noter que l'utilisation d'un bit sur le signe du signal présente un intérêt particulier lorsque le signal analogique est centré autour de zéro comme c'est le cas des signaux audio ou radio par exemple.

Le dispositif de quantification selon l'invention est un dispositif à temps continu, c'est-à-dire qu'il fournit un signal de sortie à temps continu. En d'autres termes, les deux bits du signal de sortie ne sont échantillonnés par aucune horloge.

De façon optionnelle, le circuit d'analyse d'enveloppe comporte un circuit électronique, appelé circuit de commande de variation d'enveloppe, comprenant un comparateur conçu pour fournir un signal binaire, appelé signal de comparaison entrée/enveloppe, prenant une première valeur lorsque le signal d'enveloppe est supérieur au signal d'entrée et une seconde valeur lorsque le signal d'enveloppe est inférieur au signal d'entrée, et conçu pour fournir le signal de variation d'enveloppe, à partir du signal de comparaison entrée/enveloppe, et un circuit électronique, appelé circuit de génération de signal d'enveloppe, conçu pour générer le signal d'enveloppe, de sorte que ce signal d'enveloppe soit sélectivement croissant ou décroissant suivant la valeur du signal de variation d'enveloppe.

De façon optionnelle également, le signal d'enveloppe est linéaire par morceaux, et le circuit de génération d'enveloppe est conçu pour générer le signal d'enveloppe sélectivement avec une pente positive prédéterminée et une pente négative prédéterminée, en fonction du signal de variation d'enveloppe.

De façon optionnelle également, le dispositif comporte en outre un circuit électronique, appelé circuit de comparaison entrée/enveloppe négative, conçu pour fournir un signal binaire, appelé signal de comparaison entrée/enveloppe négative, prenant une première valeur lorsque l'opposée du signal d'enveloppe est supérieure au signal d'entrée et une seconde valeur lorsque l'opposée du signal d'enveloppe est inférieure au signal d'entrée, et un circuit électronique, appelé circuit de combinaison de comparaisons, conçu pour fournir le signal de variation d'enveloppe à partir du signal de comparaison entrée/enveloppe et du signal de comparaison entrée/enveloppe négative.

De façon optionnelle également, le circuit de commande de variation d'enveloppe comporte un circuit électronique conçu pour fournir le signal de variation d'enveloppe de sorte qu'il prenne sa valeur haute sur tout un cycle du bit de signe lorsque le signal de comparaison entrée/enveloppe a pris sa valeur haute sur au moins une partie du cycle précédent du bit de signe, et sa valeur basse sinon.

De façon optionnelle également, le circuit conçu pour fournir le signal de variation d'enveloppe comporte un circuit électronique, appelé circuit de mémorisation, conçu pour fournir un signal électronique, appelé signal de comparaison entrée/enveloppe mémorisé correspondant au signal de comparaison entrée/enveloppe dans lequel une valeur haute apparaissant dans un cycle du bit de signe est mémorisée jusqu'à la fin de ce cycle.

De façon optionnelle également, le circuit conçu pour fournir le signal de variation d'enveloppe comporte un circuit électronique, appelé circuit de maintien, conçu pour fournir le signal de variation d'enveloppe correspondant au signal de comparaison entrée/enveloppe mémorisé dans lequel, pour chaque cycle du bit de signe, la valeur du signal de comparaison entrée/enveloppe mémorisé du début du cycle est capturée et maintenue jusqu'à la fin du cycle.

L'invention a également pour objet un récepteur de signaux radiofréquence comportant une antenne conçue pour capter un signal radiofréquence et le convertir en signal électrique, un dispositif de quantification selon l'invention pour quantifier un signal d'entrée obtenu à partir du signal électrique fourni par l'antenne, un circuit électronique, appelé circuit d'oscillateur radio local, conçu pour générer des premier et second signaux, appelés signaux d'oscillateur local respectivement en phase et en quadrature, en quadrature l'un de l'autre, et un circuit électronique, appelé circuit double mélangeur, conçu pour fournir deux signaux électriques binaires, appelés signaux binaires de base respectivement en phase et en quadrature correspondant au mélange du produit du signal de signe et du signal de variation d'enveloppe avec respectivement les deux signaux d'oscillateur local.

L'invention a également pour objet un procédé de quantification d'un signal analogique, appelé signal d'entrée, comportant : fournir un signal binaire, appelé signal de signe, prenant une première valeur lorsque le signal d'entrée est positif et prenant une seconde valeur lorsque le signal d'entrée est négatif, et fournir un signal binaire, appelé signal de variation d'enveloppe, prenant une première valeur, appelée valeur haute, lorsqu'un signal d'enveloppe du signal d'entrée croît, et une seconde valeur, appelée valeur basse, lorsque le signal d'enveloppe décroît.

L'invention sera mieux comprise à l'aide de la description qui va suivre, donnée uniquement à titre d'exemple et faite en se référant aux dessins annexés dans lesquels :

- la figure 1 est un schéma représentant un récepteur radio selon un premier mode de réalisation de l'invention,
- la figure 2 est un organigramme illustrant les étapes successives d'un procédé de réception mis en oeuvre par le récepteur radio de la figure 1,
- la figure 3 est un schéma représentant un récepteur radio selon un second mode de réalisation de l'invention,
- la figure 4 est un diagramme représentant l'évolution au cours du temps de signaux électriques à différents points du récepteur radio de la figure 3 lors de son fonctionnement,
- la figure 5 est un schéma représentant un récepteur radio selon un troisième mode de réalisation de l'invention,
- la figure 6 est un organigramme illustrant les étapes successives d'un procédé de réception mis en oeuvre par le récepteur radio de la figure 5,
- la figure 7 est un diagramme représentant l'évolution au cours du temps de signaux électriques à différents points du récepteur radio de la figure 5 lors de son fonctionnement,
- la figure 8 est un graphe représentant l'évolution au cours du temps de la modulation d'amplitude d'un signal modulé en amplitude et de l'enveloppe obtenue dans le récepteur radio de la figure 5.

Bien que le dispositif de quantification de l'invention soit décrit dans le cadre de récepteurs radio, l'invention n'est pas limitée à cette utilisation. En effet, le dispositif de quantification de l'invention peut être utilisé dans d'autres dispositifs, tels que par exemple les convertisseurs des signaux audio, capteurs de mouvement et de phénomènes vibratoires, et en particulier ceux comportant un convertisseur analogique numérique. L'homme du métier saura adapter le dispositif de quantification de l'invention à ces applications.

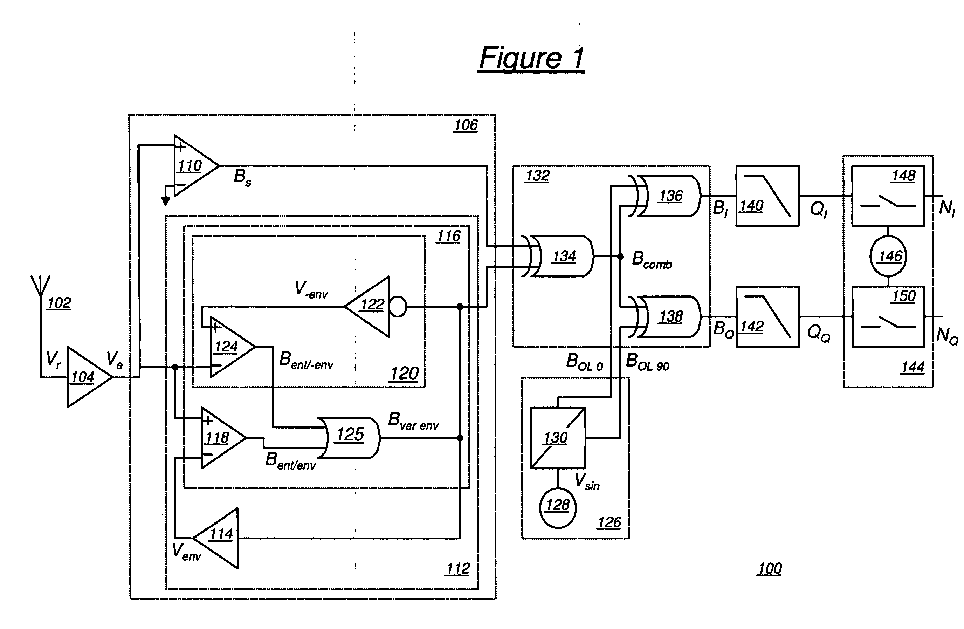

En référence à la figure 1, un récepteur radio 100 selon un premier mode de réalisation de l'invention comporte tout d'abord une antenne radio 102 conçue pour capter un signal radio et le convertir en un signal électrique noté $V_r$. Dans l'exemple décrit, le récepteur radio est un récepteur dit IQ à zéro IF, c'est-à-dire à fréquence intermédiaire nulle. Le signal radio comporte une porteuse de fréquence élevée (de 30 KiloHertz à 100 GigaHertz), modulée par un signal porteur de l'information à transmettre, se trouvant généralement dans des fréquences très inférieures à celles de la porteuse.

Le récepteur radio 100 comporte en outre un amplificateur 104 conçu pour amplifier le signal $V_r$ avec une faible contribution en bruit, tel qu'un amplificateur de type LNA (pour Low Noise Amplifier). A cet effet, l'amplificateur 104 est muni d'une entrée connectée à l'antenne radio 102 et d'une sortie fournissant un signal électrique analogique, appelé signal d'entrée $V_e$.

Le récepteur radio 100 comporte en outre un dispositif 106 de quantification du signal d'entrée $V_e$ en un signal de sortie quantifié sur deux bits. Dans l'exemple décrit, le signal de sortie comporte deux signaux électriques binaires (appelés aussi signaux logiques) à temps continu, appelés respectivement bit de signe $B_s$ et bit de variation d'enveloppe $B_{var\ env}$.

A cet effet, le dispositif de quantification 106 comporte tout d'abord un circuit électronique, appelé circuit d'analyse de signe 110, conçu pour fournir le bit de

signe $B_s$ du signal d'entrée $V_e$ de sorte qu'il prenne une valeur haute lorsque le signal d'entrée $V_e$ est positif et une valeur basse lorsque le signal d'entrée $V_e$ est négatif. Dans l'exemple décrit, le circuit d'analyse de signe 110 est un comparateur asynchrone dont l'entrée analogique positive est connectée à la sortie de l'amplificateur 104, dont l'entrée analogique négative est connectée à une masse électrique du récepteur radio 100 et dont la sortie binaire fournit le bit de signe $B_s$. Un comparateur asynchrone est un comparateur conçu pour fournir à tout instant le résultat de la comparaison de ses entrées analogiques sur sa sortie logique binaire, sans nécessiter d'horloge, de sorte que cette sortie n'est pas échantillonnée. Le comparateur 110 est ainsi conçu pour comparer le signal d'entrée $V_e$ à la masse électrique et pour fournir le bit de signe $B_s$ en fonction du résultat de la comparaison.

Le dispositif de quantification 106 comporte en outre un circuit électronique, appelé circuit d'analyse d'enveloppe 112, conçu pour fournir le bit de variation d'enveloppe $B_{var\,env}$ du signal d'entrée $V_e$ de sorte qu'il prenne une valeur haute lorsqu'un signal d'enveloppe du signal d'entrée $V_e$ croît, et une valeur basse lorsque le signal d'enveloppe décroît.

Dans l'exemple de la figure 1, le circuit d'analyse d'enveloppe 112 comporte tout d'abord un circuit électronique, appelé circuit de génération d'enveloppe 114, conçu pour générer le signal d'enveloppe $V_{env}$.

Le circuit d'analyse d'enveloppe 112 comporte en outre un circuit électronique, appelé circuit de commande de variation d'enveloppe 116, conçu pour fournir le signal de variation d'enveloppe $B_{var\,env}$, en fonction du signal d'entrée $V_e$ et du signal d'enveloppe $V_{env}$.

Dans l'exemple de la figure 1, le circuit de commande de variation d'enveloppe 116 comporte tout d'abord un circuit électronique, appelé circuit de comparaison entrée/enveloppe 118, conçu pour fournir un signal binaire, appelé signal de comparaison entrée/enveloppe $B_{ent/env}$, prenant une valeur haute et lorsque le signal d'entrée $V_e$ est supérieur au signal d'enveloppe $V_{env}$ et une valeur basse lorsque le signal d'entrée $V_e$ est inférieur au signal d'enveloppe $V_{env}$. Dans l'exemple de la figure 1, le circuit de comparaison entrée/enveloppe 118 est un comparateur asynchrone dont l'entrée analogique positive est connectée à la sortie de l'amplificateur 104, dont l'entrée analogique négative est connectée au circuit de génération d'enveloppe 114 pour recevoir le signal d'enveloppe $V_{env}$, et dont la sortie fournit le signal de comparaison entrée/enveloppe $B_{ent/env}$.

En outre, le circuit de commande de variation d'enveloppe 116 comporte un circuit électronique, appelé circuit de comparaison entrée/enveloppe négative 120, conçu pour fournir un signal électrique binaire, appelé signal de comparaison entrée/enveloppe négative $B_{ent/-env}$, prenant une valeur haute lorsque l'opposée du signal d'enveloppe est supérieure au signal d'entrée $V_e$ et une valeur basse lorsque l'opposée du signal d'enveloppe est inférieure au signal d'entrée $V_e$.

Dans l'exemple de la figure 1, le circuit de comparaison entrée/enveloppe négative 120 comporte un circuit électronique, appelé circuit générateur d'enveloppe négative 122, conçu pour générer un signal d'enveloppe négative $V_{-env}$, ayant la même valeur absolue que le signal d'enveloppe $V_{env}$, mais de signe négatif.

Le circuit de comparaison entrée/enveloppe négative 120 comporte en outre un circuit électronique, appelé circuit de comparaison entrée/enveloppe négative 124, conçu pour fournir le signal de comparaison entrée/enveloppe négative $B_{ent/-env}$, prenant une valeur haute lorsque le signal d'entrée $V_e$ est inférieur au signal d'enveloppe négative $V_{-env}$ et une valeur basse lorsque le signal d'entrée $V_e$ est supérieur au signal d'enveloppe négative $V_{-env}$. Dans l'exemple de la figure 1, le circuit de comparaison entrée/enveloppe négative 124 est un comparateur asynchrone dont l'entrée analogique négative est connectée à la sortie de l'amplificateur 104, dont l'entrée analogique positive est connectée au circuit de génération d'enveloppe négative 122 pour recevoir le signal d'enveloppe négative $V_{-env}$, et dont la sortie logique fournit le signal de comparaison entrée/enveloppe négative $B_{ent/-env}$.

Le circuit de commande de variation d'enveloppe 116 comporte en outre un circuit électronique, appelé circuit de combinaison des comparaisons 125, conçu pour fournir le signal de variation d'enveloppe $B_{var\,env}$ à partir du signal de comparaison entrée/enveloppe $B_{ent/env}$ et du signal de comparaison entrée/enveloppe négative $B_{ent/-env}$. Dans l'exemple de la figure 1, le circuit de combinaison des comparaisons 125 est une porte logique OU dont une entrée est connectée à la sortie du comparateur 118, dont l'autre entrée est connectée à la sortie du comparateur 124, et dont la sortie fournit le signal de variation d'enveloppe $B_{var\,env}$. Ainsi, le signal de variation d'enveloppe $B_{var\,env}$ prend sa valeur haute lorsque l'une des entrées est à sa valeur haute, c'est-à-dire lorsque signal d'entrée $V_e$ est supérieur au signal d'enveloppe $V_{env}$ ou inférieur au signal d'enveloppe négative $V_{-env}$, et prend sa valeur basse lorsque les deux entrées sont à leur valeur basse, c'est-à-dire lorsque le signal d'entrée $V_e$ est inférieur au signal d'enveloppe $V_{env}$ et supérieur au signal d'enveloppe négative $V_{-env}$. Ainsi, plus le signal d'enveloppe augmente vite, plus le signal de variation d'enveloppe comporte des transitions de la valeur basse à la valeur haute nombreuses et des paliers à la valeur haute longs et nombreux et, réciproquement, plus le signal d'enveloppe diminue vite, plus le signal de variation d'enveloppe comporte des transitions de la valeur haute à la valeur basse nombreuses et des paliers à la valeur basse longs et nombreux.

Dans l'exemple de la figure 1, le circuit générateur d'enveloppe 114 est un intégrateur dont l'entrée est connectée à la sortie de la porte logique OU et dont la sortie est connectée à l'entrée négative du comparateur 118. L'intégrateur 114 est conçu pour générer un signal enveloppe $V_{env}$ linéaire par morceaux, le signal d'enveloppe $V_{env}$ étant croissant avec une pente (aussi appelée constante d'intégration) positive prédéterminée lorsque le signal de variation d'enveloppe $B_{var\ env}$ est à sa valeur haute et décroissant avec une pente (aussi appelée constante d'intégration) négative prédéterminée lorsque le signal de variation d'enveloppe $B_{var\ env}$ est à sa valeur basse. La pente positive présente une valeur absolue plus grande que celle de la pente négative, de préférence au moins deux fois plus grande. En outre, les valeurs absolues des pentes sont choisies très faibles par rapport à la fréquence de la porteuse.

Dans l'exemple de la figure 1, le circuit générateur d'enveloppe négative 122 est également un intégrateur dont l'entrée est connectée à la sortie de la porte logique OU et dont la sortie est connectée à l'entrée négative du comparateur 124. L'intégrateur 122 est conçu pour générer un signal enveloppe négative $V_{-env}$ linéaire par morceaux, le signal d'enveloppe négative $V_{-env}$ étant croissant avec une pente positive prédéterminée (égale à la pente négative de l'intégrateur 114) lorsque le signal de variation d'enveloppe $B_{var\ env}$ est à sa valeur basse et décroissant avec une pente négative prédéterminée (égale à la pente positive de l'intégrateur 114) lorsque le signal de variation d'enveloppe $B_{var\ env}$ est à sa valeur haute. L'intégrateur 122 est par exemple constitué d'un intégrateur identique à l'intégrateur 114 précédé d'une porte logique NON pour obtenir des constantes de temps des deux intégrateurs de signes opposés.

Le récepteur radio 100 comporte en outre un circuit électronique, appelé circuit d'oscillateur radio local 126, conçu pour générer des premier et second signaux binaires, appelés signaux d'oscillateur local en phase $B_{OL\ 0}$ et en quadrature $B_{OL\ 90}$, en quadrature l'un de l'autre. Dans l'exemple de la figure 1, le circuit d'oscillateur radio local 126 comporte un oscillateur local 128 dont la sortie fournit un signal $V_{sin}$ qui est logique carré de valeurs -1 et +1, et un circuit électronique, appelé circuit de mise en quadrature 130, dont l'entrée est connectée à la sortie de l'oscillateur local 128 et dont les deux sorties fournissent respectivement les signaux d'oscillateur local en phase $B_{OL\ 0}$ et en quadrature $B_{OL\ 90}$.

Le récepteur radio 100 comporte en outre un circuit électronique, appelé double mélangeur 132, conçu pour mélanger le produit du signal de signe et du signal de variation d'enveloppe avec respectivement les deux signaux d'oscillateur local $B_{OL\ 0}$ et $B_{OL\ 90}$. Par « mélanger », on entend une opération dont le résultat fournit un signal présentant au moins une fréquence égale à la différence des fréquences des deux signaux mélangés et qui forme la bande de base dans un récepteur zéro IF. La bande de base est la bande de fréquences que possède le signal (indivisible) une fois démodulé ou, de façon équivalente, avant qu'il ne soit modulé. Le signal de sortie présente en outre une fréquence à la somme des fréquences des deux signaux mélangés, qui sera filtrée comme cela sera expliqué par la suite. Le double mélangeur 132 fournit ainsi deux signaux binaires mélangés respectivement en phase $B_I$ et en quadrature $B_Q$ correspondant aux deux mélanges précédents.

Dans l'exemple de la figure 1, le double mélangeur 132 comporte tout d'abord un multiplieur 134, appelé multiplieur signe/variation d'enveloppe, dont une entrée est connectée à la sortie du circuit d'analyse d'enveloppe 112, dont l'autre entrée est connectée à la sortie du comparateur 110 et dont la sortie fournit un signal binaire, appelé signal combiné $B_{comb}$, égal à la multiplication des deux signaux d'entrée $B_s$ et $B_{var\ env}$. Le multiplieur signe/variation d'enveloppe 134 est par exemple une porte logique OU exclusif.

Le double mélangeur 132 comporte en outre deux multiplieurs, appelés respectivement multiplieurs en phase 136 et en quadrature de phase 138, présentant chacun une entrée connectée à la sortie du multiplieur signe/variation d'enveloppe 134 et une autre entrée connectée, pour le multiplieur en phase 136, à la sortie du circuit de mise en quadrature 130 fournissant le signal d'oscillateur local en phase $B_{OL\ 0}$, et, pour le multiplieur en quadrature de phase 138, à la sortie du circuit de mise en quadrature 130 fournissant le signal d'oscillateur local en quadrature $B_{OL\ 90}$. Dans l'exemple de la figure 1, les multiplieurs en phase 136 et en quadrature 138 sont des portes logiques OU exclusif.

Le récepteur radio 100 comporte en outre deux filtres passe-bas, appelés filtres passe-bas respectivement de phase 140 et de quadrature 142, munis d'entrées respectivement connectées à la sortie du multiplieur en phase 136 et à la sortie du multiplieur en quadrature 138 et de sorties fournissant des signaux quantifiés, appelés signaux quantifiés de bande de base respectivement en phase $Q_I$ et en quadrature $Q_Q$. Dans l'exemple décrit, les filtres passe-bas 140 et 142 sont des filtres numériques à temps continu, c'est-à-dire que le signal de sortie est quantifié mais non échantillonné. En variante, les filtres passe-bas 140, 142 sont des filtres analogiques, par exemple de type RC, fournissant des signaux analogiques, appelés signaux analogiques de bande de base respectivement en phase $Q'_I$ et en quadrature $Q'_Q$..

Les filtres passe-bas 140, 142 sont des filtres anti-repliement, c'est-à-dire qu'ils ont pour fonction de réduire l'effet de repliement risquant de se produire dans l'échantillonneur 144 qui sera décrit plus bas. A cet effet, la fréquence de coupure des filtres passe-bas 140, 142 est choisie inférieure à la moitié de la fréquence d'échantillonnage. Ainsi, les filtres passe-bas 140, 142 ne traitent que le problème du repliement. En particulier, ils ne réalisent pas la fonction de filtrage de canal.

Le récepteur radio 100 comporte en outre un double échantillonneur 144 conçu pour échantillonner à basse fréquence les deux signaux de bande de base $Q_I$ et $Q_Q$ afin de fournir deux signaux numériques, appelés signaux de bande de base respectivement en phase $N_I$ et en quadrature $N_Q$.

Dans l'exemple de la figure 1, le double échantillonneur 144 comporte une horloge 146 munie d'une sortie fournissant un signal binaire d'horloge de bande de base, et deux échantillonneurs, appelés échantillonneurs respectivement de phase 146 et de quadrature 148, dont les entrées sont connectées à l'horloge 146 et à la sortie des filtres passe-bas anti-repliement respectivement de phase 140 et de quadrature 142, et dont les sorties fournissent les signaux numériques de bande de base en phase $N_I$ et en quadrature $N_Q$.

Dans le cas où les filtres passe-bas sont analogiques, chaque échantillonneur 146, 148 est en fait un convertisseur analogique numérique comportant un circuit de quantification (non représenté) pour, en plus de l'échantillonnage, quantifier les signaux analogiques de bande de base $Q'_I$ et $Q'_Q$.

On remarquera que l'échantillonnage est réalisé loin dans la chaîne de réception, en particulier après le mélange. Ainsi, l'échantillonnage peut être réalisé à une fréquence de bande de base, ce qui permet de réduire la consommation d'énergie du double échantillonneur 144.

Généralement, le double échantillonneur 144 sera suivi de filtres numériques (non représentés) ayant pour fonction de réaliser un vrai filtrage de canal. Ces filtres de canal sont généralement des filtres passe-bas, mais peuvent également être des filtres passe-bande. Dans les deux cas, ces filtres sont caractérisés par des pentes de coupure beaucoup plus raides que celles des filtres anti-repliement 140, 142.

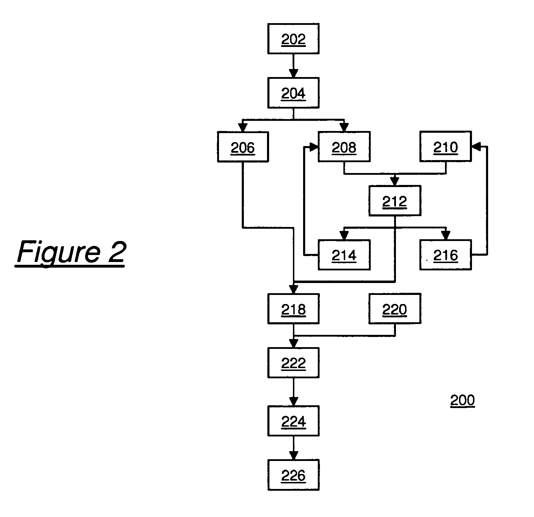

En référence à la figure 2, on va à présent décrire un procédé 200 de fonctionnement du récepteur radio 100 de la figure 1.

Au cours d'une étape 202, un signal radio est reçu par l'antenne 102 et converti en signal électrique $V_r$.

Au cours d'une étape 204, le signal électrique $V_r$ est amplifié par l'amplificateur 104 qui fournit le signal d'entrée $V_e$.

Au cours d'une étape 206, le comparateur 110 compare le signal d'entrée $V_e$ à la masse pour fournir le signal de signe $B_s$.

Au cours d'une étape 208, le comparateur 118 compare le signal d'entrée $V_e$ au signal d'enveloppe $V_{env}$ pour fournir le signal de comparaison entrée/enveloppe $B_{ent/env}$.

Au cours d'une étape 210, le comparateur 114 compare le signal d'entrée $V_e$ au signal d'enveloppe négative $V_{-env}$ pour fournir le signal de comparaison entrée/enveloppe négative $B_{ent/-env}$.

Au cours d'une étape 212, la porte logique OU 112 combine les deux comparaisons pour donner le signal de variation d'enveloppe $B_{var\ env}$. Ce signal indique dans quel sens doit varier le signal d'enveloppe.

Au cours d'une étape 214, l'intégrateur 114 génère le signal d'enveloppe $V_{env}$ utilisé à l'étape 208, suivant le signal de variation d'enveloppe $B_{var\ env}$, c'est-à-dire avec la pente positive lorsque le signal de variation d'enveloppe est à sa valeur haute, et avec la pente négative lorsque le signal de variation d'enveloppe est à sa valeur basse.

Au cours d'une étape 216, l'intégrateur 122 génère le signal d'enveloppe négative $V_{-env}$ utilisé à l'étape 210, suivant le signal de variation d'enveloppe $B_{var\ env}$, c'est-à-dire avec la pente négative lorsque le signal de variation d'enveloppe est à sa valeur haute, et avec la pente positive lorsque le signal de variation d'enveloppe est à sa valeur basse.

Au cours d'une étape 218, la porte logique OU exclusif 134 multiplie le signal de signe $B_s$ et le signal de variation d'enveloppe $B_{var\ env}$ pour fournir le signal combiné $B_{comb}$.

Au cours d'une étape 220, le circuit d'oscillateur radio local 126 fournit les signaux en quadrature $B_{OL\ 0}$ et $B_{OL\ 90}$.

Au cours d'une étape 222, les portes logiques OU exclusif 136 et 138 multiplient le signal combiné $B_{comb}$ avec respectivement le signal d'oscillateur local en phase $B_{OL\ 0}$ et le signal en quadrature $B_{OL\ 90}$.

Au cours d'une étape 224, les filtres passe-bas anti-repliement 140 et 142 filtrent les hautes fréquences des signaux $B_I$ et $B_Q$ pour fournir les signaux quantifiés de base $Q_I$ et $Q_Q$.

Enfin, au cours d'une étape 226, le double échantillonneur 144 échantillonne les signaux quantifiés de bande de base $Q_I$ et $Q_Q$ pour fournir les signaux numériques de bande de base $N_I$ et $N_Q$.

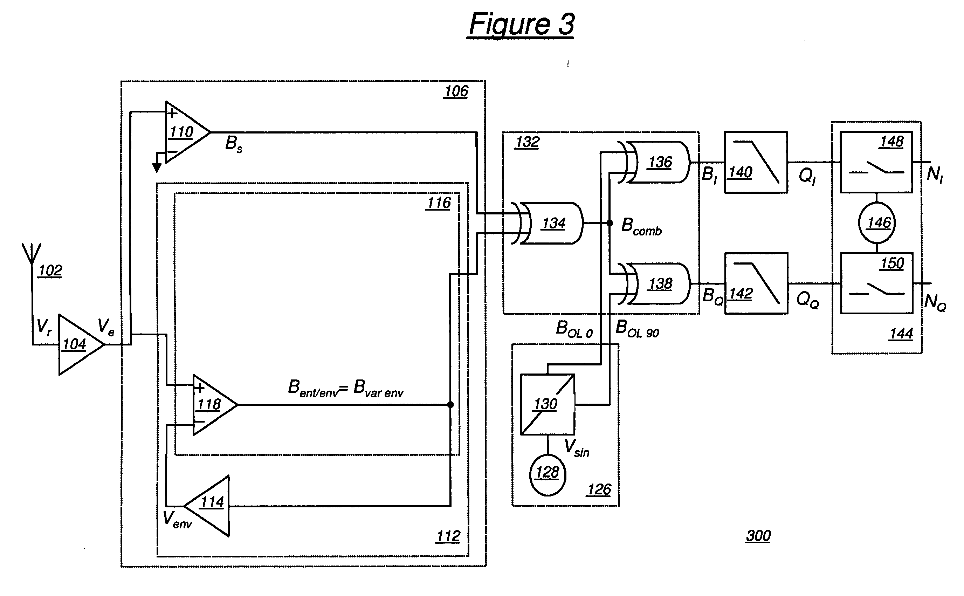

En référence à la figure 3, un récepteur radio 300 selon un second mode de réalisation de l'invention va à présent être décrit.

Le récepteur radio 300 est identique à celui de la figure 1, si ce n'est que le circuit de commande de variation d'enveloppe 116 ne comporte ni le circuit de comparaison entrée/enveloppe négative 120 ni le circuit de combinaison des comparaisons 125, de sorte que le signal de variation d'enveloppe $B_{var\ env}$ est le signal de comparaison entrée/enveloppe $B_{ent/env}$.

Le récepteur 300 présente l'avantage d'être plus simple que celui de la figure 1, sans que la qualité de la quantification soit trop dégradée dans la mesure où le signal de modulation du signal radio s'étend dans des fréquences très inférieures à celle de la porteuse de sorte que la porteuse varie très peu dans un cycle du bit de signe. Il est donc possible de négliger l'une ou l'autre des alternances de l'enveloppe et de considérer que l'enveloppe reste constante tout un cycle de bit de signe.

Le fonctionnement du récepteur radio 300 suit le procédé de la figure 2, si ce n'est que les étapes 210, 212 et 216 ne sont pas mises en oeuvre et que les étapes 214 et 218 suivent directement l'étape 208.

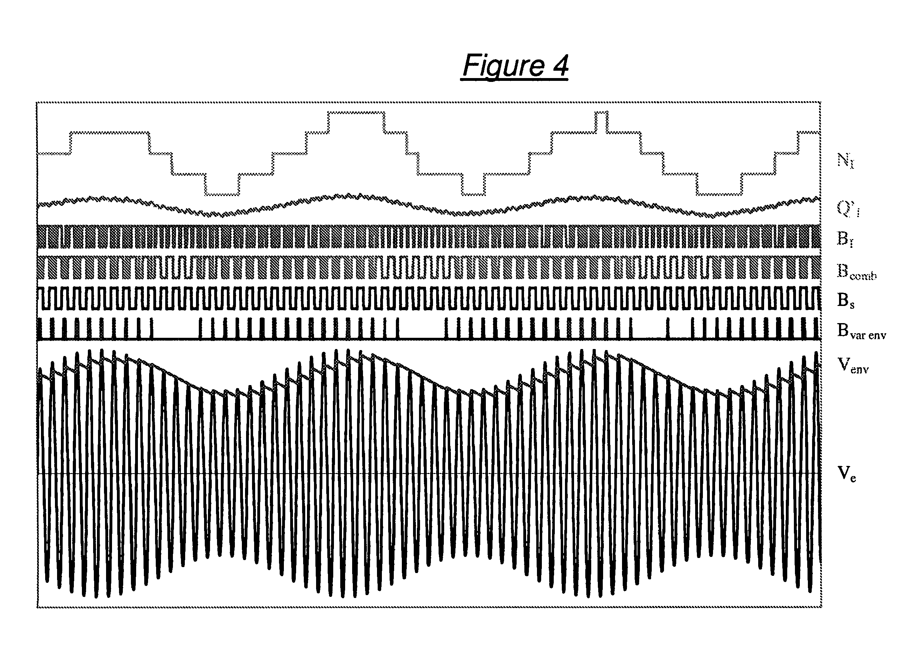

Les variations au cours du temps du signal d'entrée $V_e$, du signal d'enveloppe $V_{env}$, du signal de variation d'enveloppe $B_{var\ env}$, du signal combiné $B_{comb}$, du signal binaire de bande de base en phase $B_I$, du signal analogique filtré avant quantification ($Q'_I$), et du signal numérique de bande de base en phase $N_I$, du récepteur 300 sont illustrées sur la figure 4.

L'exemple de la figure 4 représente le cas où des filtres passe-bas 140, 142 analogiques sont utilisés. Ils présentent l'avantage d'être très simples. Sur cette figure, les valeurs haute et basse des signaux binaires ont été arbitrairement prises à respectivement -1V et +1V. Les signaux analogiques filtrés avant quantification $Q'_I$ et $Q'_I$ sont convertis en signaux numériques par les convertisseurs analogique numérique 150, 158 qui, comme ils fonctionnent à basse fréquence, sont très classiques et consomment peu d'énergie.

Le récepteur 300 présente l'avantage qu'il est possible de choisir l'amplitude des signaux filtrés de façon à ce qu'ils ne soient pas perturbés par du bruit.

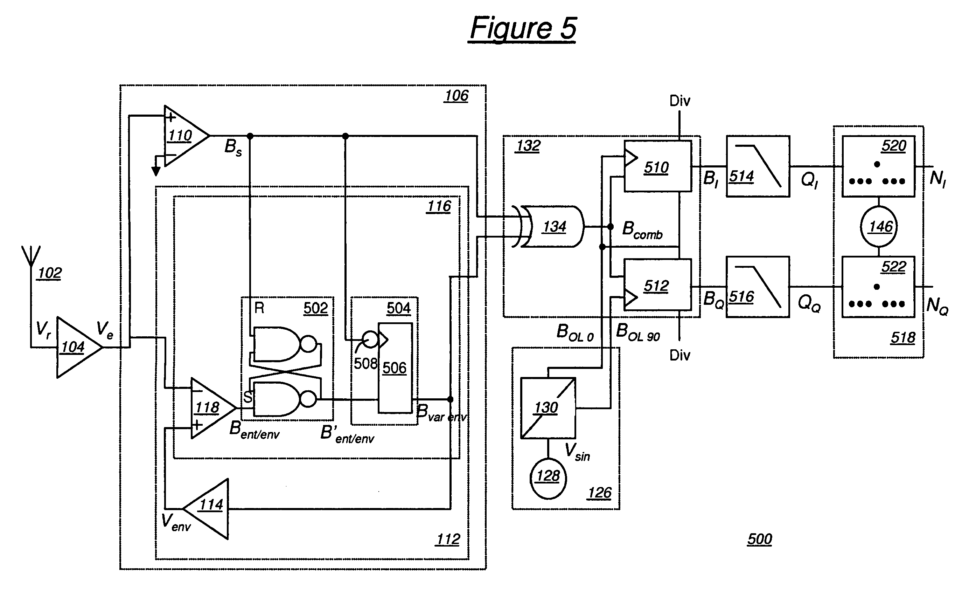

En référence à la figure 5, un récepteur radio 500 selon un troisième mode de réalisation de l'invention va à présent être décrit. Comme cela sera expliqué plus bas, ce récepteur radio 500 comporte un dispositif de quantification fournissant un bit de variation d'enveloppe $B_{var\ env}$ « pseudo échantillonné » par rapport au bit de signe $B_S$.

Le récepteur radio 500 est identique à celui de la figure 1, si ce n'est que le circuit de commande de variation d'enveloppe 116 ne comporte ni le circuit de comparaison entrée/enveloppe négative 120 ni le circuit de combinaison des comparaisons 125.

A la place, le circuit de commande de variation d'enveloppe 116 comporte tout d'abord un circuit électronique, appelé circuit de mémorisation 502, conçu pour fournir un signal électronique, appelé signal de comparaison entrée/enveloppe mémorisé $B'_{ent/env}$ correspondant au signal de comparaison entrée/enveloppe $B_{ent/env}$ dans lequel une valeur haute apparaissant dans un cycle du signal de signe $B_S$ est mémorisée, c'est-à-dire prolongée, jusqu'à la fin de ce cycle. Dans l'exemple de la figure 5, le circuit de mémorisation 502 est une bascule RS dont l'entrée R est connectée à la sortie du comparateur 110, dont l'entrée S est connectée à la sortie du comparateur 118, et dont la sortie fournit le signal de comparaison entrée/enveloppe mémorisé $B'_{ent/env}$. Dans l'exemple de la figure 5, la bascule RS 502 est réalisée à partir de portes logiques NON-ET comme cela est connu en soi.

En variante, le comparateur 118 peut être un comparateur à effet mémoire fournissant directement le signal de comparaison entrée/enveloppe mémorisé $B'_{ent/env}$.

Le circuit de commande de variation d'enveloppe 116 comporte en outre un circuit électronique, appelé circuit de maintien 504, conçu pour fournir le signal de variation d'enveloppe correspondant au signal de comparaison entrée/enveloppe mémorisé dans lequel, pour chaque cycle du bit de signe, la valeur du signal de comparaison entrée/enveloppe mémorisé du début du cycle est capturée et maintenue jusqu'à la fin du cycle. Ainsi, comme le signal de signe $B_S$ ne dépend de rien d'autre que du signal d'entrée, le signal de variation d'enveloppe $B_{var\ env}$ demeure quantifié en temps continu et n'est donc affecté par aucun repliement de spectre. Dans l'exemple décrit, la capture est réalisée sur les fronts descendants du signal de signe $B_S$. Ainsi, dans l'exemple de la figure 5, le circuit de maintien 504 est une bascule D conçue pour échantillonner sur les fronts descendants de son entrée d'horloge. Son entrée D est connectée à la sortie de la bascule RS 502, son entrée d'horloge est connectée à la sortie du comparateur 110, et sa sortie Q fournit le signal de variation d'enveloppe $B_{var\ env}$.

Ainsi, les circuits 502 et 504 forment un circuit électronique conçu pour fournir le signal de variation d'enveloppe de sorte qu'il prenne sa valeur haute sur tout un cycle du signal de signe lorsque le signal de comparaison entrée/enveloppe a pris sa valeur haute sur au moins une partie du cycle précédent du signal de signe, et sa valeur basse sinon.

Par ailleurs, dans ce mode de réalisation, les pentes positive et négative du générateur d'enveloppe 114 ont la même valeur absolue.

Le quantificateur 106 du récepteur 500 présente l'avantage de fournir un signal de variation d'enveloppe dont les transitions d'une valeur à l'autre sont espacées d'une durée toujours au moins égale à la période de la porteuse. Ainsi, les valeurs du signal de variation d'enveloppe se propagent bien dans les composants logiques qui composent le reste du récepteur 500. En outre, il est inutile d'avoir deux constantes d'intégration différentes, ce qui permet d'utiliser un intégrateur 114 ayant une seule constante d'intégration.

Par ailleurs, les multiplieurs de phase et de quadrature de la figure 1 sont remplacés par des échantillonneurs, appelés échantillonneurs respectivement de phase 510 et de quadrature 512, dont l'entrée de signal est connectée à la sortie de la porte logique 134 et dont les entrées d'horloge sont connectés aux sorties du circuit de mise en quadrature 130.

Par ailleurs, les filtres passe-bas de phase et de quadrature à temps continu sont remplacés par des filtres passe-bas de phase 514 et de quadrature 516 numériques, et en particulier à temps discret.

Par ailleurs, le double échantillonneur de la figure 1 est remplacé par un double décimateur 518 comportant deux décimateurs, appelés décimateurs respectivement de phase 520 et de quadrature 522, dont les entrées sont connectées à l'horloge basse fréquence 146 et à la sortie des filtres passe-bas respectivement de phase 514 et de quadrature 516, et dont les sorties fournissent les signaux numériques de bande de base en phase $N_I$ et en quadrature $N_Q$.

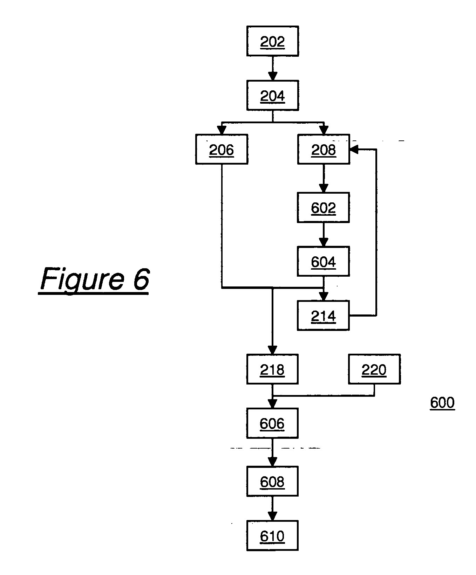

En référence à la figure 6, le fonctionnement du récepteur 500 de la figure 5 suit le procédé de la figure 2, si ce n'est pour les changements suivants.

Tout d'abord, les étapes 210, 212 et 216 sont supprimées. A la place, l'étape 208, au cours de laquelle le comparateur 118 fournit le signal de comparaison entrée/enveloppe $B_{ent/env}$, est suivie d'une étape 602, au cours de laquelle le circuit de mémorisation 502 mémorise les valeurs haute du signal de comparaison entrée/enveloppe $B_{ent/env}$ jusqu'à la fin du cycle du signal de signe $B_S$ où ils apparaissent. Ensuite, au cours d'une étape 604, le circuit de maintien 504 capture en début de cycle du signal de signe le signal ainsi mémorisé et le maintient pendant tout le cycle pour fournir le signal de variation d'enveloppe $B_{var\ env}$ utilisé à l'étape 214 et à l'étape 218.

Par ailleurs, les étapes 222 à 226 sont remplacées par les étapes 606 à 610 suivantes.

Au cours de l'étape 606, les échantillonneurs de phase 510 et de quadrature 512 échantillonnent le signal combiné $B_{comb}$ par rapport aux signaux d'oscillateur local respectivement en phase $B_{OL\ 0}$ et en quadrature $B_{OL\ 90}$ pour fournir les signaux binaires de bande de base de phase $B_I$ et de quadrature $B_Q$.

Au cours de l'étape 608, les filtres passe-bas numériques filtrent les signaux binaires de bande de base de phase $B_I$ et de quadrature $B_Q$ pour fournir les signaux numériques de bande de base de phase $Q_I$ et de quadrature $Q_Q$, ces derniers étant décimés, au cours de l'étape 610, pour fournir les signaux numériques de bande de base de phase $N_I$ et de quadrature $N_Q$ à plus basse fréquence.

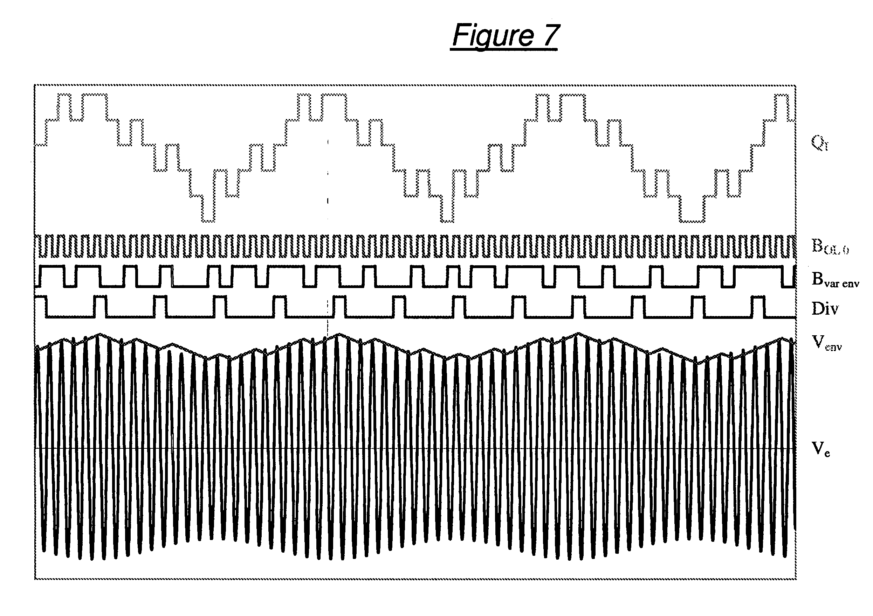

Les variations au cours du temps du signal d'entrée $V_e$, du signal d'enveloppe $V_{env}$, du signal de variation d'enveloppe $B_{var\ env}$, du signal d'oscillateur local en phase $B_{OL\ 0}$, et du signal quantifié de bande de base en phase $Q_I$, sont illustrées sur la figure 7.

On va à présent expliquer comment doit être de préférence choisie la constante d'intégration du dispositif de quantification de la figure 5, dans le cas où le signal d'entrée $V_e$ est formé d'une porteuse de période de porteuse T0 (fréquence de porteuse F0 et pulsation de porteuse ω0) modulée en amplitude. L'amplitude de la porteuse non modulée est A0 et M(t) est la fonction de modulation comprise entre 0 et 1 et qui a une bande passante notée BW, inférieure à F0. Le signal d'entrée $V_e$ est ainsi de la forme : $V_e$ = A0.M(t).sin(ω0.t)

Dans ces conditions, la constante d'intégration, notée P, de l'intégrateur 114 doit être de préférence choisie de manière à quantifier la fonction de modulation M(t) et non la porteuse. Pour que la bande de base BW ne soit pas tronquée par l'intégrateur, la constante d'intégration P doit valoir au minimum π.A0.BW qui représente la pente maximale de la plus haute fréquence dans la bande passante BW et qui se trouve à -½BW et +½BW.

Des résultats similaires peuvent être trouvés pour les autres modes de réalisation des quantificateurs de l'invention. Dans le cas d'un signal se trouvant déjà dans sa bande de base entre 0 et BW, P pourra être choisi avec la formule P ≥ 2π.A0.BW.

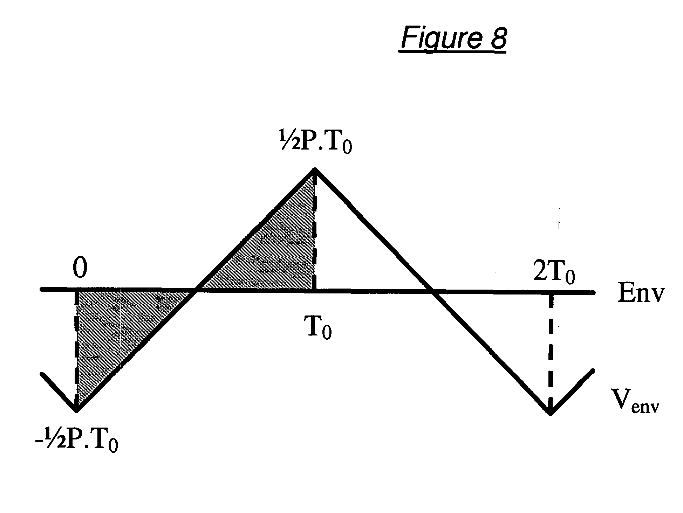

En référence à la figure 8, on va à présent chercher à exprimer le bruit de quantification du quantificateur de la figure 5, toujours dans le cas du signal d'entrée $V_e$ = A0.M(t).sin(ω0.t).

La figure 8 représente l'évolution au cours du temps de l'enveloppe théorique, notée Env, c'est-à-dire de la modulation d'amplitude, supposée constante sur cette figure, et du signal d'enveloppe $V_{env}$ obtenu en sortie de l'intégrateur 114.

Comme on peut le voir sur la figure 8, le bruit de quantification (aire hachurée) est la conséquence de l'approximation de l'enveloppe théorique du signal d'entrée par un signal triangulaire de pentes +P et -P. Entre 0 et T0, cette courbe s'exprime par : P.t - ½P.T0. Plus la constante d'intégration P est petite et plus le bruit de quantification est faible.

Le bruit de quantification en valeur RMS est donné par :

$$\sigma = \sqrt{\frac{P^2}{T_0}\int_0^{T_0}(t - T_0/2)^2.dt} = \frac{P.T_0}{\sqrt{12}}$$

On peut ainsi constater qu'on a le même bruit de quantification qu'un convertisseur analogique-numérique classique $\left(\sigma = \frac{LSB}{\sqrt{12}}\right)$. Le facteur P.T0, qui est la variation d'amplitude minimale, est l'équivalent du LSB d'un convertisseur analogique numérique classique.

Le rapport signal à bruit de la quantification peut donc être déterminé pour un signal d'amplitude A0 par :

$$SNR = \frac{\sqrt{12}}{\pi}.\frac{F_0}{BW}$$

où F0 est la fréquence de porteuse et BW la bande passante du signal d'entrée.

On voit que pour augmenter le rapport signal à bruit, il est intéressant d'augmenter la fréquence porteuse et de diminuer la largeur de bande, la largeur de bande maximale étant fixée par le choix de P.

Par exemple, en utilisant l'invention avec le standard ZigBee dans lequel la bande s'étend d'environ 2,4 GHz à 2,48 GHz, le rapport signal à bruit dans cette bande de 80 MHz atteint au moins 30 dB. Chaque canal d'émission faisant environ 2 MHz de largeur, on atteint plus de 60 dB de rapport signal à bruit par canal, c'est-à-dire l'équivalent de plus de 10 bits d'un convertisseur Flash tournant à au moins 5 GS/s.

Il apparaît donc clairement qu'un dispositif de quantification tel que celui décrit précédemment permet d'obtenir un signal quantifié sur très peu de bits (deux bits) sans trop de perte d'information.

Un dispositif de quantification selon l'invention peut être utilisé dans d'autres dispositifs qu'un récepteur radio.

**Revendications**

1. Dispositif de quantification en temps continu d'un signal analogique, appelé signal d'entrée ($V_e$), pour la fourniture d'un signal de sortie à temps continu quantifié sur deux bits, comportant un circuit électronique, appelé circuit d'analyse de signe (110), conçu pour fournir un premier bit du signal de sortie, appelé bit de signe ($B_s$), prenant à tout instant une première valeur lorsque le signal d'entrée (V$_e$) est positif et une seconde valeur lorsque le signal d'entrée (V$_e$) est négatif, **caractérisé en ce qu'**il comporte en outre un circuit électronique, appelé circuit d'analyse d'enveloppe (112), conçu pour fournir un second bit du signal de sortie, appelé bit de variation d'enveloppe (B$_{var\,env}$), prenant à tout instant une première valeur, appelée valeur haute, lorsqu'un signal d'enveloppe (V$_{env}$) du signal d'entrée croît, et une seconde valeur, appelée valeur basse, lorsque le signal d'enveloppe (V$_{env}$) décroît.

2. Dispositif selon la revendication 1, dans lequel le circuit d'analyse d'enveloppe (112) comporte :

   - un circuit électronique, appelé circuit de commande de variation d'enveloppe (116), comprenant un comparateur (118) conçu pour fournir un signal binaire, appelé signal de comparaison entrée/enveloppe (B$_{ent/env}$), prenant une première valeur lorsque le signal d'enveloppe (V$_{env}$) est supérieur au signal d'entrée (V$_e$) et une seconde valeur lorsque le signal d'enveloppe (V$_{env}$) est inférieur au signal d'entrée (V$_e$), et conçu pour fournir le signal de variation d'enveloppe (B$_{var\,env}$), à partir du signal de comparaison entrée/enveloppe (B$_{ent/env}$), et
   - un circuit électronique, appelé circuit de génération de signal d'enveloppe (114), conçu pour générer le signal d'enveloppe (V$_{env}$), de sorte que ce signal d'enveloppe soit sélectivement croissant ou décroissant suivant la valeur du signal de variation d'enveloppe (B$_{var\,env}$).

3. Dispositif selon la revendication 2, dans lequel le signal d'enveloppe (V$_{env}$) est linéaire par morceaux, et dans lequel le circuit de génération d'enveloppe (114) est conçu pour générer le signal d'enveloppe (V$_{env}$) sélectivement avec une pente positive prédéterminée et une pente négative prédéterminée, en fonction du signal de variation d'enveloppe (Bvar env).

4. Dispositif selon la revendication 2 ou 3, comportant en outre un circuit électronique, appelé circuit de comparaison entrée/enveloppe négative (120), conçu pour fournir un signal binaire, appelé signal de comparaison entrée/enveloppe négative (B$_{ent/-env}$), prenant une première valeur lorsque l'opposée du signal d'enveloppe (V$_{-env}$) est supérieure au signal d'entrée (V$_e$) et une seconde valeur lorsque l'opposée du signal d'enveloppe (V$_{-env}$) est inférieure au signal d'entrée (V$_e$), et un circuit électronique, appelé circuit de combinaison de comparaisons (112), conçu pour fournir le signal de variation d'enveloppe (B$_{var\,env}$) à partir du signal de comparaison entrée/enveloppe (B$_{ent/env}$) et du signal de comparaison entrée/enveloppe négative (B$_{ent/-env}$).

5. Dispositif selon l'une quelconque des revendications 1 à 4, dans lequel le circuit de commande de variation d'enveloppe comporte un circuit électronique (502, 504) conçu pour fournir le signal de variation d'enveloppe de sorte qu'il prenne sa valeur haute sur tout un cycle du bit de signe lorsque le signal de comparaison entrée/enveloppe a pris sa valeur haute sur au moins une partie du cycle précédent du bit de signe, et sa valeur basse sinon.

6. Dispositif selon la revendication 5, dans lequel le circuit (502, 504) conçu pour fournir le signal de variation d'enveloppe comporte un circuit électronique, appelé circuit de mémorisation (502), conçu pour fournir un signal électronique, appelé signal de comparaison entrée/enveloppe mémorisé (B'$_{ent/env}$) correspondant au signal de comparaison entrée/enveloppe (B$_{ent/env}$) dans lequel une valeur haute apparaissant dans un cycle du bit de signe (B$_S$) est mémorisée jusqu'à la fin de ce cycle.

7. Dispositif selon la revendication 6, dans lequel le circuit (502, 504) conçu pour fournir le signal de variation d'enveloppe comporte un circuit électronique, appelé circuit de maintien (504), conçu pour fournir le signal de variation d'enveloppe correspondant au signal de comparaison entrée/enveloppe mémorisé dans lequel, pour chaque cycle du bit de signe, la valeur du signal de comparaison entrée/enveloppe mémorisé du début du cycle est capturée et maintenue jusqu'à la fin du cycle.

8. Récepteur de signaux radiofréquence comportant une antenne (102) conçue pour capter un signal radiofréquence et le convertir en signal électrique (V$_r$), un dispositif de quantification (106) selon l'une quelconque des revendications 1 à 7 pour quantifier en temps continu un signal d'entrée (V$_e$) obtenu à partir du signal électrique (V$_r$) fourni par l'antenne (102), un circuit électronique, appelé circuit d'oscillateur radio local (126), conçu pour générer des premier et second signaux, appelés signaux d'oscillateur local respectivement en phase (B$_{OL\,0}$) et en quadrature (B$_{OL\,90}$), en quadrature l'un de l'autre, et un circuit électronique, appelé circuit double mélangeur (132), conçu pour fournir deux signaux électriques binaires, appelés signaux binaires de bande de base respectivement en phase (B$_I$) et en quadrature (B$_Q$) correspondant au mélange du produit (B$_{comb}$) du signal de signe (B$_s$) et du signal de variation d'enveloppe (B$_{var\,env}$) avec respectivement les deux signaux d'oscillateur local (B$_{OL\,0}$, B$_{OL\,90}$).

9. Procédé de quantification d'un signal analogique, appelé signal d'entrée, destiné à fournir un signal de sortie à temps continu quantifié sur deux bits, comportant une étape consistant à fournir un premier bit du signal de sortie, appelé bit de signe, prenant à tout instant une première valeur lorsque le signal d'entrée est positif et une seconde valeur lorsque le signal d'entrée est négatif, **caractérisé en ce qu'**il comporte en outre une étape consistant à fournir un second bit du signal de sortie, appelé bit de variation d'enveloppe, prenant à tout instant une première valeur, appelée valeur haute, lorsqu'un signal d'enveloppe du signal d'entrée croît, et une seconde valeur, appelée valeur basse, lorsque le signal d'enveloppe décroît.

**Claims**

1. Device for continuous time quantization of an analogue signal, called the input signal (Ve), in order to supply a continuous time output signal that is quantized as two bits, including an electronic circuit, called the sign analysis circuit (110), designed to supply a first bit of the output signal called the sign bit ($B_s$) which at any time takes a first value when the input signal ($V_e$) is positive and a second value when the input signal ($V_e$) is negative, **characterized in that** it further includes an electronic circuit, called the envelope analysis circuit (112), designed to supply a second bit of the output signal called the envelope variation bit ($B_{var\ env}$) which at any time takes a first value, called high value, when an envelope signal ($V_{env}$) of the input signal is increasing, and a second value, called low value, when the envelope signal ($V_{env}$) is decreasing.

2. Device according to claim 1, wherein the envelope analysis circuit (112) includes:

   - an electronic circuit, called the envelope variation command circuit (116), comprising a comparator (118) designed to supply a binary signal, called input/envelope comparison signal ($B_{ent/env}$), which takes a first value when the envelope signal ($V_{env}$) is greater than the input signal ($V_e$) and a second value when the envelope signal ($V_{env}$) is less than the input signal ($V_e$), and which is designed to supply the envelope variation signal ($B_{var\ env}$), from the input/envelope comparison signal (Bent/env), and
   - an electronic circuit, called the envelope signal generation circuit (114) designed to generate the envelope signal ($V_{env}$), so that this envelope signal is selectively increasing or decreasing depending on the value of the envelope variation signal ($B_{var\ env}$).

3. Device according to claim 2, wherein the envelope signal ($V_{env}$) is piecewise linear, and in which the envelope generation circuit (114) is designed to generate the envelope signal ($V_{env}$) selectively with a predetermined positive slope and a predetermined negative slope, depending on the envelope variation signal ($B_{var\ env}$).

4. Device according to claim 2 or 3, which includes in addition an electronic circuit called the input/negative envelope comparison circuit (120) designed to supply a binary signal, called the input/ negative envelope comparison signal ($B_{ent/-env}$), which takes a first value when the opposite of the envelope signal ($V_{-env}$) is greater than the input signal ($V_e$), and a second value when the opposite of the envelope signal ($V_{-env}$) is less than the input signal ($V_e$), and an electronic circuit called the comparisons combination circuit (112) designed to supply the envelope variation signal ($B_{var\ env}$) from the input/envelope comparison signal ($B_{ent/env}$) and from the input/negative envelope comparison signal ($B_{ent/-env}$).

5. Device according to any one of claims 1 to 4, wherein the envelope variation command circuit includes an electronic circuit (502, 504) designed to supply the envelope variation signal so that it takes its high value throughout a sign bit cycle when the input/envelope comparison signal has taken its high value over at least part of the previous sign bit cycle, and its low value otherwise.

6. Device according to claim 5, wherein the circuit (502, 504) designed to supply the envelope variation signal includes an electronic circuit, called the memorisation circuit (502), designed to supply an electronic signal, called the memorised input/envelope comparison signal ($B'_{ent/env}$) which corresponds to the input/envelope comparison signal ($B_{ent/env}$) in which a high value which appears in a sign bit cycle ($B_S$) is memorised until the end of this cycle.

7. Device according to claim 6, wherein the circuit (502, 504) designed to supply the envelope variation signal includes an electronic circuit, called the maintain circuit (504), designed to supply the envelope variation signal which corresponds to the memorised input/envelope comparison signal in which, for each sign bit cycle, the value of the input/envelope comparison signal memorised at the start of the cycle is captured and maintained up to the end of the cycle.

8. Radio-frequency signal receiver which includes an antenna (102) designed to sense a radio-frequency signal and to convert it into an electrical signal ($V_r$), a quantization device (106) according to any whatsoever of claims 1 to 7 for quantizing in continuous time an input signal ($V_e$) obtained from the electrical signal ($V_r$) supplied by the antenna (102), an electronic circuit, called the local radio oscillator circuit (126), designed to generate first and second signals called, respectively, the in-phase ($B_{OL\ 0}$) and in-quadrature ($B_{OL\ 90}$) local oscillator signals, in quadrature with each other, and an electronic circuit, called the double mixer circuit (132), designed to supply two binary electrical signals, called respectively in-phase ($B_I$) and in-quadrature ($B_Q$) base band binary signals which correspond to the mixture of the product ($B_{comb}$) of the sign signal ($B_s$) and of the envelope variation signal ($B_{var\,env}$) with, respectively, the two local oscillator signals ($B_{OL\,0}$, $B_{OL\,90}$).

9. Method for quantization of an analogue signal, called the input signal, designed to supply a continuous time output signal quantized as two bits, including a step consisting of supplying a first bit of the output signal, called the sign bit, which at any time takes a first value when the input signal is positive and a second value when the input signal is negative, **characterized in that** it further includes a step consisting of supplying a second bit of the output signal, called the envelope variation bit, which at any time takes a first value, called high value, when an envelope signal of the input signal is increasing, and a second value, called low value, when the envelope signal is decreasing.

**Patentansprüche**

1. Vorrichtung zur fortlaufenden Quantifizierung eines analogen Signals, das Eingangssignal ($V_e$) genannt wird, zur Lieferung eines fortlaufenden, mit zwei Bit quantifizierten Ausgangssignals, umfassend eine elektronische Schaltung, die Vorzeichen-Analyseschaltung (110) genannt wird und gestaltet ist, um ein erstes Bit des Ausgangssignals zu liefern, das Vorzeichenbit ($B_s$) genannt wird und immer einen ersten Wert, wenn das Eingangssignal ($V_e$) positiv ist, und einen zweiten Wert annimmt, wenn das Eingangssignal ($V_e$) negativ ist, **dadurch gekennzeichnet, dass** sie überdies eine elektronische Schaltung umfasst, die Hüllkurvenanalyseschaltung (112) genannt wird und gestaltet ist, um ein zweites Bit des Ausgangssignals zu liefern, das Hüllkurvenänderungsbit ($B_{var\,env}$) genannt wird und immer einen ersten Wert, der hoher Wert genannt wird, wenn ein Hüllkurvensignal ($V_{env}$) des Eingangssignals ansteigt, und einen zweiten Wert annimmt, der niedriger Wert genannt wird, wenn das Hüllkurvensignal ($V_{env}$) abnimmt.

2. Vorrichtung nach Anspruch 1, wobei die Hüllkurven-Analyseschaltung (112) umfasst:

- eine elektronische Schaltung, die Hüllkurvenänderungs-Steuerschaltung (116) genannt wird umfassend einen Komparator (118), der gestaltet ist, um ein binäres Signal zu liefern, das Vergleichssignal Eingang/Hüllkurve ($B_{ent/env}$) genannt wird und einen ersten Wert, wenn das

Hüllkurvensignal ($V_{env}$) größer ist als das Eingangssignal ($V_e$), und einen zweiten Wert annimmt, wenn das Hüllkurvensignal ($V_{env}$) kleiner ist als das Eingangssignal ($V_e$), und gestaltet ist, um ausgehend von dem Vergleichssignal Eingang/Hüllkurve ($B_{ent/env}$) das Hüllkurvenänderungssignal ($B_{var\,env}$) zu liefern, und
- eine elektronische Schaltung, die Hüllkurvensignal-Erzeugungsschaltung (114) genannt wird und gestaltet ist, um das Hüllkurvensignal ($V_{env}$) derart zu erzeugen, dass das Hüllkurvensignal gemäß dem Wert des Hüllkurvenänderungssignals ($B_{var\,env}$) selektiv ansteigt oder abnimmt.

3. Vorrichtung nach Anspruch 2, wobei das Hüllkurvensignal ($V_{env}$) stückweise linear ist und wobei die Hüllkurven-Erzeugungsschaltung (114) gestaltet ist, um das Hüllkurvensignal ($V_{env}$) in Abhängigkeit vom Hüllkurvenänderungssignal ($B_{var\,env}$) selektiv mit einer vorbestimmten positiven Steigung und einer vorbestimmten negativen Steigung zu erzeugen.

4. Vorrichtung nach Anspruch 2 oder 3, überdies umfassend eine elektronische Schaltung, die Vergleichsschaltung Eingang/negative Hüllkurve (120) genannt wird und gestaltet ist, um ein binäres Signal zu liefern, das Vergleichssignal Eingang/negative Hüllkurve ($B_{ent/-env}$) genannt wird und einen ersten Wert, wenn das Hüllkurvensignal ($V_{-env}$) mit entgegengesetztem Vorzeichen größer ist als das Eingangssignal ($V_e$), und einen zweiten Wert annimmt, wenn das Hüllkurvensignal ($V_{-env}$) mit entgegengesetztem Vorzeichen kleiner ist als das Eingangssignal ($V_e$), und eine elektronische Schaltung, die Vergleichskombinations-Schaltung (112) genannt wird und gestaltet ist, um das Hüllkurvenänderungssignal ($B_{var\,env}$) ausgehend von dem Vergleichssignal Eingang/Hüllkurve ($B_{ent/env}$) und dem Vergleichssignal Eingang/negative Hüllkurve ($B_{ent/-env}$) zu liefern.

5. Vorrichtung nach einem der Ansprüche 1 bis 4, wobei die Hüllkurvenänderungs-Steuerschaltung eine elektronische Schaltung (502, 504) umfasst, die gestaltet ist, um das Hüllkurvenänderungssignal derart zu liefern, dass es, wenn das Vergleichssignal Eingang/Hüllkurve über mindestens einen Abschnitt des vorhergehenden Zyklus des Vorzeichenbits seinen hohen Wert angenommen hat, über einen gesamten Zyklus des Vorzeichenbits seinen hohen Wert und anderenfalls seinen niedrigen Wert annimmt.

6. Vorrichtung nach Anspruch 5, wobei die Schaltung (502, 504), die gestaltet ist, um das Hüllkurvenänderungssignal zu liefern, eine elektronische Schaltung umfasst, die Speicherschaltung (502) genannt wird und gestaltet ist, um ein elektronisches Signal zu liefern, das gespeichertes Vergleichssignal Eingang/Hüllkurve (B'$_{ent/env}$) genannt wird und dem Vergleichssignal Eingang/Hüllkurve (B$_{ent/env}$) entspricht, in dem ein hoher Wert, der in einem Zyklus des Vorzeichenbits (B$_s$) auftritt, bis zum Ende dieses Zyklus gespeichert wird.

7. Vorrichtung nach Anspruch 6, wobei die Schaltung (502, 504), die gestaltet ist, um das Hüllkurvenänderungssignal zu liefern, eine elektronische Schaltung umfasst, die Halteschaltung (504) genannt wird und gestaltet ist, um das Hüllkurvenänderungssignal zu liefern, das dem gespeicherten Vergleichssignal Eingang/Hüllkurve entspricht, in dem für jeden Zyklus des Vorzeichenbits der zu Beginn des Zyklus gespeicherte Wert des Vergleichssignals Eingang/Hüllkurve erfasst und bis zum Ende des Zyklus gehalten wird.

8. Funksignalempfänger, umfassend eine Antenne (102), die gestaltet ist, um ein Funksignal zu empfangen und es in ein elektrisches Signal (V$_r$) umzuwandeln, eine Quantifizierungsvorrichtung (106) nach einem der Ansprüche 1 bis 7 zum fortlaufenden Quantifizieren eines ausgehend von dem durch die Antenne (102) gelieferten elektrischen Signal (V$_r$) erhaltenen Eingangssignals (V$_e$), eine elektronische Schaltung, die Lokalfunk-Oszillatorschaltung (126) genannt wird und gestaltet ist, um erste und zweite Signale zu erzeugen, die In-Phase- (B$_{OL\,0}$) beziehungsweise Quadratur-Lokaloszillatorsignale (B$_{OL\,90}$) genannt werden, die in Quadratur zueinander stehen, und eine elektronische Schaltung, die Mischerdoppelschaltung (132) genannt wird und gestaltet ist, um zwei binäre elektrische Signale zu liefern, die binäre In-Phase- (B$_I$) beziehungsweise Quadratur-Basisbandsignale (B$_Q$) genannt werden und der Mischung des Produkts (B$_{comb}$) des Vorzeichensignals (B$_S$) und des Hüllkurvenänderungssignals (B$_{var\,env}$) mit den jeweiligen zwei Lokaloszillatorsignalen (B$_{OL\,0}$, B$_{OL\,90}$) entsprechen.

9. Quantifizierungsverfahren eines analogen Signals, das Eingangssignal genannt wird, das dazu bestimmt ist, ein fortlaufend mit zwei Bit quantifiziertes Ausgangssignal zu liefern, umfassend einen Schritt, der darin besteht, ein erstes Bit des Ausgangssignals zu liefern, das Vorzeichenbit genannt wird und immer einen ersten Wert, wenn das Eingangssignal positiv ist, und einen zweiten Wert annimmt, wenn das Eingangssignal negativ ist, **dadurch gekennzeichnet, dass** es überdies einen Schritt umfasst, der darin besteht, ein zweites Bit des Ausgangssignals zu liefern, das Hüllkurvenänderungsbit genannt wird und immer einen ersten Wert, der hoher Wert genannt wird, wenn ein Hüllkurvensignal des Eingangssignals ansteigt, und einen zweiten Wert annimmt, der niedriger Wert genannt wird, wenn das

Hüllkurvensignal abnimmt.

Figure 1

*Figure 2*

_Figure 3_

EP 2 383 892 B1

Figure 4

EP 2 383 892 B1

## Figure 5

*Figure 6*

Figure 7

EP 2 383 892 B1

## Figure 8

## RÉFÉRENCES CITÉES DANS LA DESCRIPTION

**Documents brevets cités dans la description**

- FR 2922388

- US 7324037 B

**Littérature non-brevet citée dans la description**

- **I. WANG ; S. LIU.** 1V 5-bit 5GS/s CMOS ADC for UWB receivers. *International Symposium on VLSI Design, Automation and Test,* 25 Avril 2007, 1-4

- **S-W CHEN ; E. W. BRODERSEN.** A Subsampling Radio Architecture for Ultrawideband Communications. *IEEE Transactions on Signal Processing,* Octobre 2007, vol. 55 (10), 5018-5031